(19) Europäisches Patentamt
European Patent Office
Office européen des brevets

(11) **EP 2 539 723 B1**

(12) **EUROPÄISCHE PATENTSCHRIFT**

(45) Veröffentlichungstag und Bekanntmachung des Hinweises auf die Patenterteilung:
**01.04.2015 Patentblatt 2015/14**

(51) Int Cl.:
*G01R 31/12* *(2006.01)*    *G01R 31/14* *(2006.01)*
*G01R 31/34* *(2006.01)*    *G01M 13/04* *(2006.01)*

(21) Anmeldenummer: **11707103.5**

(22) Anmeldetag: **02.02.2011**

(86) Internationale Anmeldenummer:
**PCT/EP2011/051486**

(87) Internationale Veröffentlichungsnummer:
**WO 2011/104084 (01.09.2011 Gazette 2011/35)**

(54) **AUSWERTUNGSVERFAHREN FÜR LICHTBOGENENTLADUNGEN UND ZUGEHÖRIGER PRÜFSTAND**

ELECTRIC ARC DISCHARGE EVALUATION METHOD, AND ASSOCIATED TEST STAND

PROCÉDÉ D'ÉVALUATION DE DÉCHARGES EN ARC ET BANC D'ESSAI ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.02.2010 DE 102010002296**

(43) Veröffentlichungstag der Anmeldung:
**02.01.2013 Patentblatt 2013/01**

(73) Patentinhaber: **Siemens Aktiengesellschaft 80333 München (DE)**

(72) Erfinder:
- **GATTERMANN, Sven 90513 Zirndorf (DE)**
- **KOWALEWSKI, Ralf 90768 Fürth (DE)**
- **PROBOL, Carsten 91054 Buckenhof (DE)**
- **TISCHMACHER, Hans 91207 Lauf (DE)**

(56) Entgegenhaltungen:
EP-A1- 0 632 283    EP-A1- 2 244 080
WO-A1-03/060536    WO-A1-2008/151176
WO-A1-2009/063118    WO-A2-2004/025811
CH-A5- 646 795    DE-A1- 2 616 075
DE-A1- 3 941 495    DE-A1- 4 132 533
DE-A1- 4 410 639    DE-A1- 4 441 828
FR-A1- 2 408 873    FR-A1- 2 573 199
GB-A- 1 462 760    GB-A- 2 096 770
US-A- 4 739 256    US-A- 5 955 880
US-B1- 7 539 549

- MOHAMED EL HACHEMI BENBOUZID: "A Review of Induction Motors Signature Analysis as a Medium for Faults Detection", IEEE TRANSACTIONS ON INDUSTRIAL ELECTRONICS, IEEE SERVICE CENTER, PISCATAWAY, NJ, USA, Bd. 47, Nr. 5, 1. Oktober 2000 (2000-10-01), XP011023717, ISSN: 0278-0046
- VMD JAGANNATH ET AL: "WiBeaM:Wireless Bearing Monitoring System", COMMUNICATION SYSTEMS SOFTWARE AND MIDDLEWARE, 2007. COMSWARE 2007. 2N D INTERNATIONAL CONFERENCE ON, IEEE, PI, 1. Januar 2007 (2007-01-01), Seiten 1-8, XP031113948, ISBN: 978-1-4244-0613-5
- HAMER P S: "Acceptance testing of electric motors and generators", 19881002; 19881002 - 19881007, 2. Oktober 1988 (1988-10-02), Seiten 1291-1304, XP010519250,
- MAKARAND S BALLAL ET AL: "Adaptive Neural Fuzzy Inference System for the Detection of Inter-Turn Insulation and Bearing Wear Faults in Induction Motor", IEEE TRANSACTIONS ON INDUSTRIAL ELECTRONICS, IEEE SERVICE CENTER, PISCATAWAY, NJ, USA, Bd. 54, Nr. 1, 1. Februar 2007 (2007-02-01), Seiten 250-258, XP011163568, ISSN: 0278-0046, DOI: DOI: 10.1109/TIE.2006.888789

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- **TISCHMACHER H ET AL: "Bearing currents in converter operation", ELECTRICAL MACHINES (ICEM), 2010 XIX INTERNATIONAL CONFERENCE ON, IEEE, PISCATAWAY, NJ, USA, 6. September 2010 (2010-09-06), Seiten 1-8, XP031779623, ISBN: 978-1-4244-4174-7**
- **NAVARRO L ET AL: "Condition monitoring system for characterization of electric motor ball bearings with distributed fault using fuzzy inference tools", INSTRUMENTATION AND MEASUREMENT TECHNOLOGY CONFERENCE (I2MTC), 2010 IEEE, IEEE, PISCATAWAY, NJ, USA, 3. Mai 2010 (2010-05-03), Seiten 1159-1163, XP031691618, ISBN: 978-1-4244-2832-8**

**Beschreibung**

Die vorliegende Erfindung betrifft ein Auswertungsverfahren für Lichtbogenentladungen, die zwischen einem Lagerinnenring und einem Lageraußenring eines Wälzlagers auftreten.

Die vorliegende Erfindung betrifft weiterhin einen Prüfstand für ein Wälzlager, das einen Lagerinnenring, einen Lageraußenring und zwischen Lagerinnenring und Lageraußenring abrollende Wälzelemente aufweist.

Bei umrichtergespeisten Motoren treten parasitäre Effekte auf, welche sich durch einen Stromfluss über das Motorlager äußern. In der Folge können über dem Schmierfilm des Lagers Lichtbodenentladungen auftreten, welche im Extremfall zu Materialaufschmelzungen und damit zu Veränderungen in den Lagerlaufbahnen führen. Diese Veränderungen können auf lange Sicht zu Schäden der Lagerung führen, die bis zum Totalausfall der Lagerung reichen können.

Zur Erfassung der Lichtbogenentladungen und der Lagerströme werden im Stand der Technik bisher nur Messungen im gesamten Antriebssystem ausgeführt, das aus Umrichter und Motor besteht. Eine isolierte Beeinflussung der Betriebsparameter des Wälzlagers ist bei dieser Vorgehensweise nicht möglich. Der Betriebszustand des Wälzlagers stellt sich vielmehr auf Grund der äußeren Gegebenheiten "irgendwie" ein. Parameterversuche, bei welchen gezielt ganze Kennfelder abgefahren werden, können auf diese Weise nicht durchgeführt werden.

Um ein Ausmaß für die durch die Lichtbogenentladungen möglicherweise bewirkten Schädigungen des Wälzlagers gewinnen zu können, wird im Stand der Technik die Stromdichte der Lichtbogenentladungen erfasst. Dies führt jedoch nur zu unbefriedigenden Korrelationen zwischen der Belastung des Wälzlagers durch die Lichtbogenentladungen einerseits und der dadurch bewirkten Schädigung des Wälzlagers andererseits.

Für die Ausbildung einer Lagerschädigung sind eine Reihe von Parametern verantwortlich. Darunter fallen zum einen natürlich der Lagerstrom und die zugehörige Lagerspannung. Zum anderen fallen darunter weitere Parameter, beispielsweise der mechanische und thermische Betriebszustand des Lagers. Drehzahl, mechanische Schwingung, Temperatur usw. beeinflussen die Dicke des Schmierfilms und damit die Wahrscheinlichkeit einer Lichtbodenentladung. Um feststellen zu können, welchen Einfluss die einzelnen Parameter auf die Lichtbogenentladungen und die damit verbundene Lagerschädigung haben, ist es erforderlich, diese Parameter isoliert steuern zu können. Nur so lassen sich mögliche Abhängigkeiten bis hin zu zulässigen Grenzwerten bestimmen.

Aus der DE 44 41 828 A1 ist ein Verfahren zur Gleitlagerdiagnose mittels Magnetfeldmessung bekannt. Bei diesem Verfahren wird in die Maschinenwelle ein Strom eingespeist. Der Ableitstrom durch das Lager wird über eine Differenzmessung des Stromes, der vor dem Lager und nach dem Lager in der Welle fließt, ermittelt. Der eingespeiste Strom ist ein Wechselstrom. Zur Ermittlung der Ströme werden die durch die Ströme erzeugten Magnetfelder gemessen.

Aus der US 2005/184 751 A1 ist ein Verfahren zur Erfassung von Funkenaktivität einer elektrischen Maschine bekannt. Bei diesem Verfahren wird zur Erfassung der Funkenaktivität die Wellenspannung und/oder der Wellenstrom gemessen und analysiert. Bei der Funkenaktivität kann es sich um zwischen Teilen der Wellenlager auftretende Wellenerosionsfunken handeln.

Aus der DE 44 10 639 A1 ist ein Prüfstand für ein Wälzlager bekannt, wobei das Wälzlager einen Lagerinnenring, einen Lageraußenring und zwischen Lagerinnenring und Lageraußenring abrollende Wälzelemente aufweist. Der Prüfstand weist einen Grundkörper auf, der seinerseits eine Montageanordnung aufweist, in der das Wälzlager lösbar montierbar ist. Der Prüfstand weist weiterhin einen drehzahlveränderlichen elektrischen Antrieb auf, der auf den Grundkörper ortsfest angeordnet ist und auf eine Welle wirkt, die bei montiertem Wälzlager drehfest mit dem Lagerinnenring oder dem Lageraußenring verbunden ist. Bei diesem Prüfstand erfolgt eine rein mechanische Prüfung des Wälzlagers.

Aus der DE 198 44 822 A1 sind in einer Antriebssteuerung für eine Verbrennungskraftmaschine (konkret: einen Automotor) in einem nicht flüchtigen Speicher Grenzwerte hinterlegt, die maximal zulässige Beschleunigungen des Kraftfahrzeugs in Abhängigkeit vom jeweils eingelegten Gang angeben.

Eine erste Aufgabe der vorliegenden Erfindung besteht darin, ein Auswertungsverfahren für Lichtbogenentladungen zwischen Lagerinnenring und Lageraußenring eines Wälzlagers zu schaffen, das - im Gegensatz zum Stand der Technik: zuverlässige - Vorhersagen über von den Lichtbogenentladungen hervorgerufene oder nicht hervorgerufene Lagerschäden ermöglicht.

Eine zweite Aufgabe der vorliegenden Erfindung besteht darin, einen entsprechenden Prüfstand zu schaffen, mittels dessen das oben genannte Auswertungsverfahren durchführbar ist.

Die erste Aufgabe wird durch ein Auswertungsverfahren mit den Merkmalen des Anspruchs 1 gelöst. Vorteilhafte Ausgestaltungen des Auswertungsverfahrens sind Gegenstand der abhängigen Ansprüche 2 bis 5.

Bei dem erfindungsgemäßen Auswertungsverfahren ist vorgesehen,

- dass ein definierter Betriebszustand des Wälzlagers eingestellt wird,
- dass zum Einstellen des definierten Betriebszustandes mindestens einer der Parameter Drehzahl des Wälzlagers, Temperatur des Wälzlagers, am Wälzlager angreifende, Schwingungen verursachende Unwucht, Schmiermittel, Axial-, Radial-, Kippbelastung, Verkippung des Lagerinnenrings relativ zum Lageraußenring, Pulsform und Pulswiederholfrequenz der angelegten elektrischen Spannung, Lagerspiel und Vorschädigung des Wälzlagers eingestellt wird,

- dass in dem definierten Betriebszustand durch Anlegen einer pulsförmigen elektrischen Spannung zwischen Lagerinnenring und Lageraußenring eine Vielzahl von Lichtbogenentladungen generiert wird,
- dass für jede Lichtbogenentladung mindestens ein Wert erfasst wird, der für die Energie, die Leistung, die Spannung, den Strom und/oder der die Dauer der jeweiligen Lichtbogenentladung charakteristisch ist, und
- dass nur diejenigen Lichtbogenentladungen ausgewertet werden, bei denen ein in Abhängigkeit von mindestens einem der erfassten charakteristischen Werte der jeweiligen Lichtbogenentladung ermittelter qualifizierender Wert oberhalb eines vorbestimmten Grenzwertes liegt.

Die erfindungsgemäße Lösung beruht auf dem Ansatz, dass es nicht auf die Lichtbogenentladungen als solche ankommt. Es kommt vielmehr auf mindestens einen charakteristischen Wert der jeweiligen Lichtbogenentladung an. Insbesondere kommt es darauf an, auf welches Volumen sich die Energie der jeweiligen Lichtbogenentladung verteilt. Lagerschäden treten nur dann auf, wenn der volumenbezogene Energieeintrag der Lichtbogenentladung zu Materialverdampfungen führt.

Die Ausbreitung der durch die Lichtbogenentladung in den Lagerinnenring bzw. den Lageraußenring eingebrachten Energie erfolgt im Wesentlichen mit der Schallgeschwindigkeit des entsprechenden Materials. Die Ausbreitungswelle weist weiterhin im Wesentlichen die Form einer Halbkugel auf. Ihr Radius ist gleich dem Produkt von Dauer der Lichtbogenentladung und Schallgeschwindigkeit des Materials von Lagerinnenring bzw. Lageraußenring. Der qualifizierende Wert ist daher nicht nur von der Energie der jeweiligen Lichtbogenentladung abhängig, sondern auch von deren Dauer. Besonders gute Werte haben sich in Praxisversuchen ergeben, wenn der qualifizierende Wert proportional zur Energie und indirekt proportional zur dritten Potenz der Dauer der jeweiligen Lichtbogenentladung ist.

Der vorbestimmte Grenzwert kann auf beliebige Weise bestimmt werden, insbesondere experimentell. Vorzugsweise ist der vorbestimmte Grenzwert bezüglich des Materials, aus dem der Lagerinnenring und/oder der Lageraußenring bestehen, durch die Erwärmungsenthalpie, die erforderlich ist, um das Material von der Betriebstemperatur auf die Schmelztemperatur zu erhitzen, durch die Schmelzenthalpie, die erforderlich ist, um das Material zu schmelzen, und durch die Erwärmungsenthalpie, die erforderlich ist, um das Material von der Schmelztemperatur auf die Siedetemperatur zu erhitzen, bestimmt, wobei die genannten Enthalpien auf dasselbe Volumen bezogen sind. Insbesondere kommt es zu Materialverdampfungen, wenn die volumenbezogene Energie der Lichtbogenentladung die Enthalpie übersteigt, die durch die Summe der genannten Enthalpien gegeben ist.

Wird diese Enthalpie überschritten, kommt es zu einer Materialverdampfung. Ist die volumenbezogene Energie sogar größer als die obige Summe zuzüglich der Verdampfungsenthalpie, welche erforderlich ist, um das Material zu verdampfen, erfolgt sogar eine vollständige Verdampfung des entsprechenden Volumens.

Um Vorhersagen für (nahezu) beliebige Betriebszustände machen zu können, wird das Auswertungsverfahren für eine Vielzahl von Betriebszuständen des Wälzlagers wiederholt. Für jeden Betriebszustand wird die Häufigkeit der ausgewerteten Lichtbogenentladungen ermittelt. In Abhängigkeit von der für den jeweiligen Betriebszustand ermittelten Häufigkeit werden die Betriebszustände als zulässig oder als unzulässig klassifiziert. Insbesondere können Betriebszustände, bei denen gar keine oder nur wenige "kritische" Lichtbogenentladungen (d.h. Lichtbogenentladungen, bei denen der qualifizierende Wert - oberhalb des vorbestimmten Grenzwertes liegt) auftreten, als zulässig klassifiziert werden, Betriebszustände, bei denen viele kritische Lichtbogenentladungen auftreten, als unzulässig. Gegebenenfalls sind auch Zwischenabstufungen wie beispielsweise "kritisch, aber kurzzeitig zulässig" oder "für begrenzte Zeit zulässig" möglich.

Die Anzahl an variierbaren Parametern des Wälzlagers kann nach Bedarf bestimmt werden.

Das erfindungsgemäße Auswertungsverfahren kann beispielsweise dazu verwendet werden, in einen nichtflüchtigen Speicher, der Bestandteil einer Antriebssteuerung für einen umrichtergespeisten elektrischen Motor ist, der ein Wälzlager aufweist, einzuschreiben

- entweder nur die als zulässig klassifizierten Betriebszustände des Wälzlagers
- oder nur die als unzulässig klassifizierten Betriebszustände des Wälzlagers
- oder zusammen mit ihrer jeweiligen Klassifizierung sowohl die als zulässig klassifizierten Betriebszustände des Wälzlagers als auch die als unzulässig klassifizierten Betriebszustände des Wälzlagers.

In diesem Fall kann die Antriebssteuerung im laufenden Betrieb selbst erkennen, ob ein lagerschädigender Betriebszustand des Wälzlagers vorliegt bzw. droht und gegebenenfalls entsprechende Maßnahmen ergreifen. Zwei Beispiele:

- In einem bestimmten Drehzahlbereich treten Schwingungen auf, die zu kritischen Lichtbogenentladungen führen. Die Antriebssteuerung versucht nach Möglichkeit, diesen Drehzahlbereich zu vermeiden. Beispielsweise kann an einen Bediener einer Maschinensteuerung ein entsprechender Warnhinweis ausgegeben werden, wenn die angeforderte Betriebsweise der Maschine den entsprechenden Drehzahlbereich bewirkt. Auch kann die Antriebssteuerung beim Beschleunigen und Abbremsen, also in den Fällen, in denen der entsprechende Drehzahlbereich nicht vermieden werden kann, den Motor mit maximalem Motormoment ansteuern, um den kritischen Drehzahlbereich möglichst schnell zu durchlaufen.

- In einem bestimmten Betriebszustand treten kritische Lichtbogenentladungen auf, wenn der Antrieb mit mehr als 80% seines vollen Betriebsstroms beaufschlagt wird. Die Antriebssteuerung begrenzt den Betriebsstrom auf maximal 75% des vollen Betriebsstroms.

Die vorliegende Erfindung betrifft daher ebenfalls eine Antriebssteuerung für einen umrichtergespeisten elektrischen Motor, der ein Wälzlager aufweist, mit einem nichtflüchtigen Speicher, in den eingeschrieben sind

- entweder nur als zulässig klassifizierte Betriebszustände des Wälzlagers
- oder nur als unzulässig klassifizierte Betriebszustände des Wälzlagers
- oder zusammen mit ihrer jeweiligen Klassifizierung sowohl als zulässig klassifizierte Betriebszustände des Wälzlagers als auch als unzulässig klassifizierte Betriebszustände des Wälzlagers.

Entscheidend ist hierbei jedoch, dass die in den nichtflüchtigen Speicher eingeschriebenen Betriebszustände gemäß einem erfindungsgemäßen Auswertungsverfahren ermittelt wurden und dass die Betriebszustände jeweils mindestens einen der Parameter Drehzahl des Wälzlagers, Temperatur des Wälzlagers, am Wälzlager angreifende, Schwingungen verursachende Unwucht, Schmiermittel, Axial-, Radial-, Kippbelastung, Verkippung des Lagerinnenrings relativ zum Lageraußenring, Pulsform und Pulswiederholfrequenz der angelegten elektrischen Spannung, Lagerspiel und Vorschädigung des Wälzlagers umfassen.

Die zweite Aufgabe wird durch einen Prüfstand mit den Merkmalen des Anspruchs 7 gelöst. Vorteilhafte Ausgestaltungen des erfindungsgemäßen Prüfstands sind Gegenstand der abhängigen Ansprüche 8 bis 15.

Erfindungsgemäß ist der eingangs erwähnte Prüfstand dadurch weitergebildet,

- dass der Prüfstand einen Grundkörper aufweist,
- dass der Grundkörper eine Montageanordnung aufweist, in der das Wälzlager lösbar montierbar ist,
- dass die Montageanordnung aus einem elektrisch isolierenden Material besteht und/oder durch ein aus einem elektrisch isolierenden Material bestehendes Zwischenelement vom übrigen Grundkörper elektrisch isoliert ist,
- dass der Prüfstand einen drehzahlveränderlichen elektrischen Antrieb aufweist, der auf dem Grundkörper ortsfest angeordnet ist und auf eine Welle wirkt, die bei montiertem Wälzlager drehfest mit dem Lagerinnenring oder dem Lageraußenring verbunden ist,

- dass der elektrische Antrieb vom Wälzlager elektrisch isoliert ist,
- dass der Prüfstand einen Spannungsgenerator aufweist, über den der Übergang von Lagerinnenring zu Lageraußenring mit einer pulsförmigen elektrischen Spannung mit einstellbarer Pulsform und Pulswiederholfrequenz beaufschlagbar ist, und
- dass der Prüfstand eine Erfassungseinrichtung aufweist, mittels derer mindestens ein Wert erfassbar ist, der für die Energie, die Leistung, die Spannung, den Strom und/oder die Dauer von zwischen dem Lagerinnenring und dem Lageraußenring auftretenden Lichtbogenentladungen charakteristisch ist.

Vorzugsweise ist auf der Welle ein Belastungslager angeordnet, mittels dessen eine statische und/oder dynamische Belastung auf das Wälzlager ausübbar ist. Beispielsweise kann der Prüfstand zum Ausüben der statischen und/oder dynamischen Belastung ein auf das Belastungslager wirkendes hydraulisches System aufweisen. Die auf das Wälzlager ausübbare Belastung kann axial, radial und/oder asymmetrisch wirken.

Vorzugsweise ist weiterhin auf der Welle eine Unwuchtscheibe angeordnet, mittels derer eine Schwingungen verursachende Unwucht auf das Wälzlager ausübbar ist. Die Unwuchtscheibe kann zu diesem Zweck mindestens eine Halteeinrichtung zum Halten einer Unwuchtmasse aufweisen.

In einer weiterhin bevorzugten Ausgestaltung des Prüfstands ist vorgesehen, dass der Prüfstand mindestens eine Temperaturbeeinflussungseinrichtung zum aktiven Einstellen einer Betriebstemperatur des Wälzlagers aufweist. Alternativ oder zusätzlich kann der Prüfstand eine Verstelleinrichtung zum Verkippen des Lagerinnenrings relativ zum Lageraußenring aufweisen. Alternativ oder zusätzlich können an der Montageanordnung Beschleunigungssensoren angeordnet sein, mittels derer horizontale und/oder vertikale Beschleunigungen der Montageanordnung erfassbar sind.

Weitere Vorteile und Einzelheiten ergeben sich aus der nachfolgenden Beschreibung von Ausführungsbeispielen in Verbindung mit den Zeichnungen. Es zeigen in Prinzipdarstellung:

FIG 1      schematisch einen Prüfstand für ein Wälzlager und

FIG 2      schematisch ein Auswertungsverfahren für Lichtbogenentladungen.

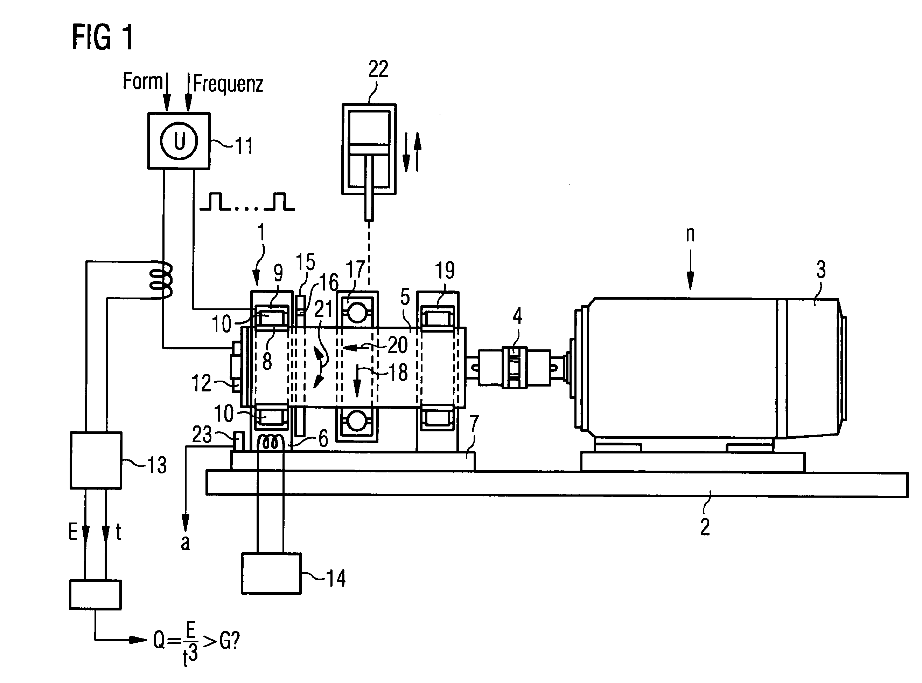

Gemäß FIG 1 weist ein Prüfstand für ein Wälzlager 1 einen Grundkörper 2 auf. Auf dem Grundkörper 2 ist (unter anderem) ortsfest ein elektrischer Antrieb 3 angeordnet. Der elektrische Antrieb 3 ist zumindest drehzahlregelbar, oftmals zusätzlich auch momentregelbar. Der elektrische Antrieb 3 wirkt auf eine Welle 5. Zwischen dem elektrischen Antrieb 3 und der Welle 5 kann eine Kupplung 4 angeordnet sein.

Der elektrische Antrieb 3 ist vom Wälzlager 1 elektrisch isoliert. Beispielsweise kann zu diesem Zweck die Kupplung 4 aus elektrisch isolierendem Material bestehen.

Der Grundkörper 2 weist eine Montageanordnung 6 auf. Die Montageanordnung 6 kann aus einem elektrisch isolierenden Material bestehen. Alternativ oder zusätzlich kann ein Zwischenelement 7 vorhanden sein, das aus einem elektrisch isolierenden Material besteht und über welches die Montageanordnung 6 vom übrigen Grundkörper 2 elektrisch isoliert ist. In der Montageanordnung 6 ist das Wälzlager 1 lösbar montierbar.

Das Wälzlager 1 weist - wie allgemein üblich - einen Lagerinnenring 8 und einen Lageraußenring 9 sowie Wälzelemente 10 auf. Die Wälzelemente 10 rollen im Betrieb des Wälzlagers 1 zwischen dem Lagerinnenring 8 und dem Lageraußenring 9 ab. In der Montageanordnung 6 ist im montierten Zustand des Wälzlagers 1 einer der Lagerringe 8, 9 - in der Regel der Lageraußenring 9 - ortsfest gehalten. Der andere der Lagerringe 8, 9 - in der Regel der Lagerinnenring 8 - ist bei montiertem Wälzlager 1 mit der Welle 5 drehfest verbunden.

Der Prüfstand weist weiterhin einen Spannungsgenerator 11 auf. Über den Spannungsgenerator 11 ist das Wälzlager 1 mit einer elektrischen Spannung U beaufschlagbar. Insbesondere ist gemäß der Darstellung von FIG 1 je einer von zwei Ausgängen des Spannungsgenerators 11 mit dem Lagerinnenring 8 und dem Lageraußenring 9 verbunden. Die Verbindung mit dem mit der Welle 5 drehfest verbundenen Lagerring 8 (in der Regel dem Lagerinnenring 8) kann beispielsweise über einen Schleifring 12 erfolgen. Dadurch, dass der Spannungsgenerator 11 mit beiden Lagerringen 8, 9 elektrisch verbunden ist, wird im Ergebnis die vom Spannungsgenerator 11 ausgegebene elektrische Spannung U an den Übergang vom Lagerinnenring 8 zu Lageraußenring 9 angelegt.

Der Spannungsgenerator 11 kann nach Bedarf ausgebildet sein. Vorzugsweise ist der Spannungsgenerator 11 derart ausgebildet, dass die vom Spannungsgenerator 11 abgegebene elektrische Spannung U, wie in FIG 1 dargestellt ist, pulsförmig ist. Die Form der vom Spannungsgenerator 11 abgegebenen Spannungspulse (Anstiegszeit, Höhe, Haltedauer, Abfallzeit) ist einstellbar. Ebenso ist die Pulswiederholfrequenz einstellbar. Beispielsweise kann der Spannungsgenerator 11 einen Funktionsgenerator umfassen, dem ein Leistungsverstärker nachgeordnet ist.

Auf Grund der angelegten Spannungspulse können zwischen dem Lagerinnenring 8 und dem Lageraußenring 9 Lichtbogenentladungen auftreten. Zur Erfassung von charakteristischen Werten der Lichtbogenentladungen - insbesondere von deren Energie E und/oder deren Dauer t - weist der Prüfstand (mindestens) eine entsprechende Erfassungseinrichtung 13 auf.

Die mittels der Erfassungseinrichtung 13 erfassten Werte können nach Bedarf bestimmt sein. Beispielsweise können die zeitlichen Verläufe der zwischen Lagerinnenring 8 und Lageraußenring 9 anstehenden Spannung oder der über das Wälzlager 1 fließende Strom erfasst werden. Insbesondere kann ein Spannungseinbruch bzw. ein Stromanstieg als Indiz für eine Lichtbogenentladung gewertet werden. Die genannten zeitlichen Verläufe können beispielsweise mittels eines entsprechend schnellen Speicheroszilloskops angezeigt und gespeichert werden.

Auch die Erfassung anderer Größen ist möglich. Beispielsweise kann ein Frequenzspektrum der durch die Lichtbogenentladungen generierten elektromagnetischen Störungen oder der zeitliche Verlauf von erzeugten elektrischen und/oder magnetischen Feldern erfasst werden. Auch kann die Leistung der Lichtbogenentladungen erfasst werden.

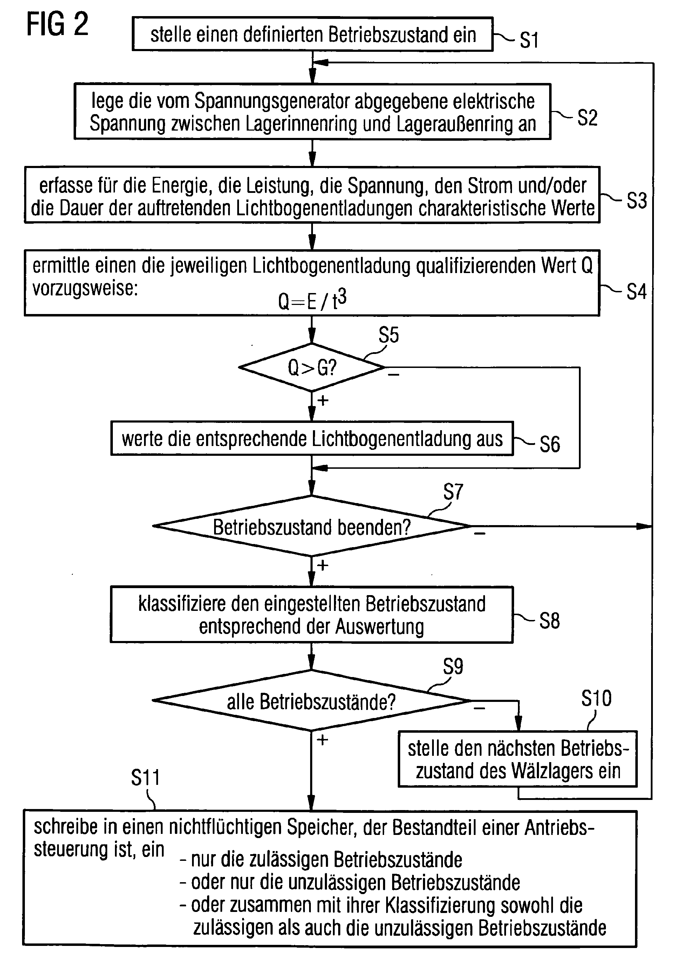

Der erfindungsgemäße Prüfstand wird gemäß FIG 2 wie folgt betrieben.

Zunächst wird in einem Schritt S1 ein definierter Betriebszustand des Wälzlagers 1 eingestellt. Auf die Einstellmöglichkeiten wird später näher eingegangen werden. Sodann wird in einem Schritt S2 die vom Spannungsgenerator 11 abgegebene elektrische Spannung U zwischen Lagerinnenring 8 und Lageraußenring 9 angelegt. In einem Schritt S3 werden die charakteristischen Werte - vorzugsweise für die Energie E und die Dauer t - der auftretenden Lichtbogenentladungen erfasst.

In einem Schritt S4 wird - automatisch oder manuell - ein die jeweilige Lichtbogenentladung qualifizierender Wert Q ermittelt. Die Ermittlung des qualifizierenden Wertes Q erfolgt im Rahmen des Schrittes S4 in Abhängigkeit von den erfassten charakteristischen Werten der jeweiligen Lichtbogenentladung. Vorzugweise erfolgt die Ermittlung in Abhängigkeit von der Energie E und der Dauer t der jeweiligen Lichtbogenentladung. Insbesondere kann die Ermittlung gemäß der Beziehung

$$Q = E/t^3$$

erfolgen.

In einem Schritt S5 wird geprüft, ob der qualifizierende Wert Q oberhalb eines vorbestimmten Grenzwertes G liegt. Wenn dies der Fall ist, wird in einem Schritt S6 die entsprechende Lichtbogenentladung ausgewertet. Im einfachsten Fall wird zu diesem Zweck ein Zähler inkrementiert. Anderenfalls wird der Schritt S6 übersprungen.

Der Grenzwert G kann nach Bedarf bestimmt sein. Insbesondere kann der Grenzwert G durch die in der Beschreibungseinleitung genannten Enthalpien des Materials bestimmt sein, aus dem der Lagerinnenring 8 und/oder der Lageraußenring 9 bestehen. Es wird zur Vermeidung von Wiederholungen auf die entsprechenden Ausführungen in der Beschreibungseinleitung verwiesen.

In einem Schritt S7 wird geprüft, ob der im Schritt S1 eingestellte Betriebszustand beendet werden soll. Wenn dies nicht der Fall ist, wird zum Schritt S2 zurückgegangen. Anderenfalls wird zu einem Schritt S8 übergegangen. Das Entscheidungskriterium des Schrittes S7 kann nach Bedarf bestimmt sein. In den einfachsten Fällen ist das Entscheidungskriterium ein Zeitablauf, die Ausgabe einer vorbestimmten Anzahl von Pulsen durch den Spannungsgenerator 11 oder die Eingabe einer Abbruchanweisung durch einen Benutzer.

Im Schritt S8 wird der im Schritt S1 eingestellte Betriebszustand entsprechend der Auswertung des Schrittes S6 klassifiziert. Die Klassifizierung enthält zumindest die Abstufungen "zulässig" und "unzulässig". Gegebenenfalls können zusätzlich Zwischenabstufungen vorhanden sein, beispielsweise die Zwischenabstufung "zulässig, aber kritisch" oder die Zwischenabstufung "nur kurzzeitig zulässig". Im einfachsten Fall erfolgt die Einstufung in Abhängigkeit von der Anzahl (= Häufigkeit) der im Schritt S6 aufsummierten Lichtbogenentladungen.

In einem Schritt S9 wird geprüft, ob bereits alle Betriebszustände durchlaufen wurden. Wenn dies nicht der Fall ist, wird zu einem Schritt S10 übergegangen, in dem der nächste Betriebszustand des Wälzlagers 1 eingestellt wird.

Vorzugsweise ist zusätzlich ein Schritt S11 vorhanden. Der Schritt S11 ist jedoch nur optional, also nicht zwingend erforderlich. Wenn der Schritt S11 vorhanden ist, werden in einen nichtflüchtigen Speicher, der Bestandteil einer Antriebssteuerung ist, Betriebszustände eingeschrieben. Hierbei ist es möglich, dass in den Speicher nur die zulässigen Betriebszustände eingeschrieben werden, nicht aber die anderen Betriebszustände. In diesem Fall ist es zwar möglich, dass zusätzlich die Information vorhanden ist, dass diese Betriebszustände zulässig sind. Zwingend ist dies aber nicht erforderlich, da sich die Zulässigkeit der Betriebszustände bereits durch den Umstand ergibt, dass diese Betriebszustände in den Speicher eingeschrieben werden.

In analoger Weise ist es möglich, in den Speicher nur die unzulässigen Betriebszustände einzuschreiben. Auch in diesem Fall kann zusätzlich die Information eingespeichert werden, dass diese Betriebszustände zulässig sind. Erforderlich ist dies aber nicht mehr.

Vorzugsweise werden sowohl die zulässigen als auch die unzulässigen Betriebszustände in den Speicher eingeschrieben. In diesem Fall muss das Einschreiben zusammen mit der Klassifizierung erfolgen. Dies kann dadurch erfolgen, dass den einzelnen Betriebszuständen jeweils deren Klassifizierung zugeordnet wird. In diesem Fall wird jedem einzelnen Betriebszustand die entsprechende Klassifizierung einzeln zugeordnet. Alternativ können die Betriebszustände nach ihren einzelnen Klassifizierungen gruppiert werden. Welche Vorgehensweise im Detail ergriffen wird, ist zweitrangig. Entscheidend ist, dass nachträglich noch ermittelbar ist, welcher Betriebszustand wie klassifiziert ist.

Im Rahmen von FIG 2 wird eine Vielzahl von Betriebszuständen eingestellt. Für jeden Betriebszustand werden die Schritte S2 bis S8 durchlaufen. Zum Einstellen der Vielzahl von Betriebszuständen des Wälzlagers 1 kann eine Vielzahl von Parametern variiert werden. Nachfolgend werden einige der Variationsmöglichkeiten aufgelistet. Selbstverständlich sind Kombinationen möglich.

So kann beispielsweise die Drehzahl n des Wälzlagers 1 variiert werden. Diese Variierung erfolgt - selbstverständlich - durch entsprechende Ansteuerung des elektrischen Antriebs 3.

Alternativ oder zusätzlich kann eine Temperatur des Wälzlagers 1 variiert werden. Zu diesem Zweck weist der Prüfstand gegebenenfalls (mindestens) eine Temperaturbeeinflussungseinrichtung 14 auf, mittels derer die Betriebstemperatur des Wälzlagers 1 aktiv einstellbar ist. In der Regel ist die Temperaturbeeinflussungseinrichtung 14 entsprechend der Darstellung von FIG 1 als Heizeinrichtung ausgebildet. In Einzelfällen ist jedoch auch eine Ausbildung als Kühleinrichtung möglich.

Alternativ oder zusätzlich kann eine am Wälzlager 1 angreifende Unwucht variiert werden. Die Unwucht verursacht mechanische Schwingungen. Zum Variieren der Unwucht kann beispielsweise auf der Welle 5 eine Unwuchtscheibe 15 angeordnet sein, mittels derer die Unwucht auf das Wälzlager 1 ausübbar ist. Die Unwuchtscheibe 15 kann eine Halteeinrichtung 16 aufweisen. Die Halteeinrichtung 16 dient dem Halten einer (in FIG 1 nicht dargestellten) Unwuchtmasse.

Alternativ kann ein Schmiermittel, das zum Schmieren des Wälzlagers 1 verwendet wird, variiert werden. Als Variationsmöglichkeiten kommen in diesem Fall insbesondere die Zusammensetzung und das Alter des Schmiermittels in Frage.

Alternativ oder zusätzlich kann eine Belastung des Wälzlagers 1 variiert werden. Beispielsweise kann auf der Welle 5 ein Belastungslager 17 angeordnet sein, mittels dessen eine Belastung auf die Welle 5 und damit indirekt auf das Wälzlager 1 ausübbar ist. Die Belastung kann alternativ statisch, dynamisch oder - ähnlich einer Überlagerung einer Gleich- und einer Wechselspannung - kombiniert statisch und dynamisch sein.

Die Art und Weise, wie die Belastung auf das Belastungslager 17 aufgebracht wird, kann nach Bedarf gewählt sein. Beispielsweise kann entsprechend dem Pfeil 18 eine radiale Belastung ausgeübt werden. In diesem Fall sollte die Welle 5 vorzugsweise zusätzlich zur Lagerung im Wälzlager 1 in einem weiteren Wälzlager 19 gelagert sein. Wenn das weitere Wälzlager 19 vorhanden ist, sollte das weitere Wälzlager 19 zum Wälzlager 1 und/oder zum restlichen Prüfstand hin elektrisch isoliert sein.

Alternativ kann gemäß dem Pfeil 20 eine axiale Belastung ausgeübt werden. In diesem Fall kann das weitere Wälzlager 19 vorhanden sein. Dies ist jedoch nicht erforderlich. Wiederum alternativ kann gemäß dem Pfeil 21 eine Kippbelastung erfolgen. In diesem Fall sollte das weitere Wälzlager 19 vorzugsweise nicht vorhanden sein, da anderenfalls die Welle 5 nicht oder nur in geringem Umfang verkippbar wäre.

Das Verkippen der Welle 5 bewirkt in dem Fall, dass das Wälzlager 1 nur ein relativ geringes Lagerspiel aufweist, dass auf das Wälzlager 1 die genannte Kippbelastung wirkt. Wenn hingegen das Wälzlager 1 ein hinreichend großes Lagerspiel aufweist, erfolgt ein im Wesentlichen kraftfreies Verkippen des Lagerinnenrings 8 relativ zum Lageraußenring 9. Auch die Verkippung des Lagerinnenrings 8 relativ zum Lageraußenring 9 und das Lagerspiel sind daher einstellbare Parameter des Wälzlagers 1. Das Belastungslager 17 kann somit auch zum Verkippen des Lagerinnenrings 8 relativ zum Lageraußenring 9 verwendet werden.

Die Art und Weise, auf die das Belasten des Belastungslagers 17 bewirkt wird, kann ebenfalls nach Bedarf gewählt werden. Beispielsweise kann der Prüfstand zum Ausüben der statischen und/oder dynamischen Belastung auf das Belastungslager 17 ein hydraulisches System 22 aufweisen, welches auf das Belastungslager 17 wirkt. Das hydraulische System 22 kann entsprechend der Darstellung von FIG 1 insbesondere als Hydraulikzylindereinheit ausgebildet sein. Das Belastungslager 17 sollte ebenfalls zum Wälzlager 1 hin und/oder zum hydraulischen System 22 hin elektrisch isoliert sein.

Bereits erwähnt wurde, dass die Pulsform und die Pulswiederholfrequenz der angelegten elektrischen Spannung U variiert werden können. Durch Variieren dieser Werte kann die Simulation der elektrischen Belastung des Wälzlagers 1 in einem umrichtergespeisten Motor simuliert werden.

Ein weiterer einstellbarer Parameter ist eine Vorschädigung des Wälzlagers 1, beispielsweise durch eine entsprechende Kerbe.

Die Erfassungseinrichtung 13 zum Erfassen der für die Energie E und die Dauer t der Lichtbogenentladungen charakteristischen Werte stellt eine Minimalausstattung an Sensorik des Prüfstandes dar. In der Regel sind weitere Sensoren vorhanden. Insbesondere können an der Montageanordnung 6 Beschleunigungssensoren 23 angeordnet sein, mittels derer horizontale und/oder vertikale Beschleunigungen a der Montageanordnung 6 erfassbar sind.

Die vorliegende Erfindung weist viele Vorteile auf. Insbesondere können mittels des erfindungsgemäßen Prüfstandes nahezu beliebige Betriebszustände des Wälzlagers 1 auf ihre Schädlichkeit in Bezug auf Riffelbildung durch Lagerströme untersucht werden. Bei Einspeicherung der zulässigen und/oder unzulässigen Betriebszustände in den nichtflüchtigen Speicher der Antriebssteuerung kann weiterhin eine automatische Berücksichtigung dieser Zustände im laufenden Betrieb desjenigen Antriebs erfolgen, der von der Antriebssteuerung gesteuert wird. Der guten Ordnung halber wird darauf hingewiesen, dass es sich bei diesem Antrieb nicht um den elektrischen Antrieb 3 des Prüfstandes handelt, sondern um denjenigen Antrieb, für den das Wälzlager 1 eigentlich bestimmt ist.

Die obige Beschreibung dient ausschließlich der Erläuterung der vorliegenden Erfindung. Der Schutzumfang der vorliegenden Erfindung soll hingegen ausschließlich durch die beigefügten Ansprüche bestimmt sein.

**Patentansprüche**

1. Auswertungsverfahren für Lichtbogenentladungen, die zwischen einem Lagerinnenring (8) und einem Lageraußenring (9) eines Wälzlagers (1) auftreten,

   - wobei ein definierter Betriebszustand des Wälzlagers (1) eingestellt wird,
   - wobei zum Einstellen des definierten Betriebszustandes mindestens einer der Parameter Drehzahl (n) des Wälzlagers (1), Temperatur des Wälzlagers (1), am Wälzlager (1) angreifende, Schwingungen verursachende Unwucht, Schmiermittel, Axial-, Radial- und Kippbelastung, Verkippung des Lagerinnenrings (8) relativ zum Lageraußenring (9), Pulsform und Pulswiederholfrequenz der angelegten elektrischen Spannung (U), Lagerspiel und Vorschädigung des Wälzlagers (1) eingestellt wird,
   - wobei in dem definierten Betriebszustand durch Anlegen einer pulsförmigen elektrischen Spannung (U) zwischen Lagerinnenring (8) und Lageraußenring (9) eine Vielzahl von Lichtbogenentladungen generiert wird,
   - wobei für jede Lichtbogenentladung mindestens ein Wert erfasst wird, der für die Energie (E), die Leistung, die Spannung, den Strom und/oder die Dauer (t) der jeweiligen Lichtbogenentladung charakteristisch ist, und
   - wobei nur diejenigen Lichtbogenentladungen ausgewertet werden, bei denen ein in Abhängigkeit von mindestens einem der erfassten charakteristischen Werte der jeweiligen Lichtbogenentladung ermittelter qualifizierender Wert (Q) oberhalb eines vorbestimmten Grenzwertes (G) liegt.

2. Auswertungsverfahren nach Anspruch 1, **dadurch gekennzeichnet**, dass der qualifizierende Wert (Q) proportional zur Energie (E) und indirekt proportional zur dritten Potenz der Dauer (t) der jeweiligen Lichtbogenentladung ist.

3. Auswertungsverfahren nach Anspruch 1 oder 2, **dadurch gekennzeichnet**, dass der vorbestimmte Grenzwert (G) bezüglich des Materials, aus dem der Lagerinnenring (8) und/oder der Lageraußenring (9) bestehen, durch die Erwärmungsenthalpie, die erforderlich ist, um das Material von der Betriebstemperatur auf die Schmelztemperatur zu erhitzen, durch die Schmelzenthalpie, die erforderlich ist, um das Material zu schmelzen, und durch die Erwärmungsenthalpie, die erforderlich ist, um das Material von der Schmelztemperatur auf die Siedetemperatur zu erhitzen, bestimmt, wobei die genannten Enthalpien auf dasselbe Volumen bezogen sind.

4. Auswertungsverfahren nach Anspruch 1, 2 oder 3, **dadurch gekennzeichnet** , dass es für eine Vielzahl von Betriebszuständen des Wälzlagers (1) wiederholt wird, dass für jeden Betriebszustand die Häufigkeit der ausgewerteten Lichtbogenentladungen ermittelt wird und dass die Betriebszustände in Abhängigkeit von der für den jeweiligen Betriebszustand ermittelten Häufigkeit als zulässig oder als unzulässig klassifiziert werden.

5. Auswertungsverfahren nach Anspruch 4, **dadurch gekennzeichnet** , dass in einen nichtflüchtigen Speicher, der Bestandteil einer Antriebssteuerung für einen umrichergespeisten elektrischen Motor, der ein Wälzlager (1) aufweist, ist, eingeschrieben werden

- entweder nur die als zulässig klassifizierten Betriebszustände des Wälzlagers (1),
- oder nur die als unzulässig klassifizierten Betriebszustände des Wälzlagers (1),
- oder zusammen mit ihrer jeweiligen Klassifizierung sowohl die als zulässig klassifizierten Betriebszustände des Wälzlagers (1) als auch die als unzulässig klassifizierten Betriebszustände des Wälzlagers (1).

6. Antriebssteuerung für einen umrichergespeisten elektrischen Motor, der ein Wälzlager (1) aufweist, mit einem nichtflüchtigen Speicher, in den eingeschrieben sind

- entweder nur als zulässig klassifizierte Betriebszustände des Wälzlagers (1),
- oder nur als unzulässig klassifizierte Betriebszustände des Wälzlagers (1),
- oder zusammen mit ihrer jeweiligen Klassifizierung sowohl als zulässig klassifizierte Betriebszustände des Wälzlagers (1) als auch als unzulässig klassifizierte Betriebszustände des Wälzlagers (1),
wobei die in den nichtflüchtigen Speicher eingeschriebenen Betriebszustände gemäß einem Auswertungsverfahren nach Anspruch 4 ermittelt wurden und die Betriebszustände des Wälzlagers (1) **jeweils mindestens einen der Parameter Drehzahl des Wälzlagers, Temperatur des Wälzlagers, am Wälzlager angreifende, Schwingungen verursachende Unwucht,**

**Schmiermittel, Axial-, Radial-, Kippbelastung, Verkippung des Lagerinnenrings relativ zum Lageraußenring, Pulsform und Pulswiederholfrequenz der angelegten elektrischen Spannung, Lagerspiel und Vorschädigung des Wälzlagers umfassen.**

7. Prüfstand für ein Wälzlager (1), das einen Lagerinnenring (8), einen Lageraußenring (9) und zwischen Lagerinnenring (8) und Lageraußenring (9) abrollende Wälzelemente (10) aufweist,

- wobei der Prüfstand einen Grundkörper (2) aufweist,
- wobei der Grundkörper (2) eine Montageanordnung (6) aufweist, in der das Wälzlager (1) lösbar montierbar ist,
- wobei die Montageanordnung (6) aus einem elektrisch isolierenden Material besteht und/oder durch ein aus einem elektrisch isolierenden Material bestehendes Zwischenelement (7) vom übrigen Grundkörper (2) elektrisch isoliert ist,
- wobei der Prüfstand einen drehzahlveränderlichen elektrischen Antrieb (3) aufweist, der auf dem Grundkörper (2) ortsfest angeordnet ist und auf eine Welle (5) wirkt, die bei montiertem Wälzlager (1) drehfest mit dem Lagerinnenring (8) oder dem Lageraußenring (9) verbunden ist,
- wobei der elektrische Antrieb (3) vom Wälzlager (1) elektrisch isoliert ist,
- wobei der Prüfstand einen Spannungsgenerator (11) aufweist, über den der Übergang von Lagerinnenring (8) zu Lageraußenring (9) mit einer pulsförmigen elektrischen Spannung (U) mit einstellbarer Pulsform und Pulswiederholfrequenz beaufschlagbar ist,
- wobei der Prüfstand eine Erfassungseinrichtung (13) aufweist, mittels derer mindestens ein Wert erfassbar ist, der für die Energie (E), die Leistung, die Spannung, den Strom und/oder die Dauer (t) von zwischen dem Lagerinnenring (8) und dem Lageraußenring (9) auftretenden Lichtbogenentladungen charakteristisch ist.

8. Prüfstand nach Anspruch 7, **dadurch gekennzeichnet,** dass auf der Welle (5) ein Belastungslager (17) angeordnet ist, mittels dessen eine statische und/oder dynamische Belastung auf das Wälzlager (1) ausübbar ist.

9. Prüfstand nach Anspruch 8, **dadurch gekennzeichnet** , dass der Prüfstand zum Ausüben der statischen und/oder dynamischen Belastung ein auf das Belastungslager (17) wirkendes hydraulisches System (22) aufweist.

10. Prüfstand nach Anspruch 8 oder 9, **dadurch**

**gekennzeichnet**, dass die auf das Wälzlager (1) ausübbare Belastung axial, radial und/oder asymmetrisch wirkt.

11. Prüfstand nach einem der Ansprüche 7 bis 10, **dadurch gekennzeichnet**, dass auf der Welle (5) eine Unwuchtscheibe (15) angeordnet ist, mittels derer eine Schwingungen verursachende Unwucht auf das Wälzlager (1) ausübbar ist.

12. Prüfstand nach Anspruch 11, **dadurch gekennzeichnet**, dass die Unwuchtscheibe (15) mindestens eine Halteeinrichtung (16) zum Halten einer Unwuchtmasse aufweist.

13. Prüfstand nach einem der Ansprüche 7 bis 12, **dadurch gekennzeichnet**, dass der Prüfstand mindestens eine Temperaturbeeinflussungseinrichtung (14) zum aktiven Einstellen einer Betriebstemperatur des Wälzlagers (1) aufweist.

14. Prüfstand nach einem der Ansprüche 7 bis 13, **dadurch gekennzeichnet,** dass der Prüfstand eine Verstelleinrichtung (17) zum Verkippen des Lagerinnenrings (8) relativ zum Lageraußenring (9) aufweist.

15. Prüfstand nach einem der Ansprüche 7 bis 14, **dadurch gekennzeichnet**, dass an der Montageanordnung (6) Beschleunigungssensoren (23) angeordnet sind, mittels derer horizontale und/oder vertikale Beschleunigungen (a) der Montageanordnung (6) erfassbar sind.

**Claims**

1. Analysis method for electric arc discharges which occur between an inner bearing ring (8) and an outer bearing ring (9) in a roller bearing (1),

   - wherein a defined operating state of the roller bearing (1) is set,
   - wherein, for the purpose of setting the defined operating state, at least one of the parameters: rotational speed (n) of the roller bearing (1); temperature of the roller bearing (1); an imbalance which causes vibrations imposed on the roller bearing (1); the lubricants; axial, radial, tilting loadings; tilting of the inner bearing ring (8) relative to the outer bearing ring (9); the pulse shape and pulse repetition frequency of the applied electrical voltage (U); bearing play and pre-existing damage to the roller bearing (1), is set,
   - wherein, in the defined operating state, a plurality of electric arc discharges is generated by applying a pulse-shaped electrical voltage (U) between the inner bearing ring (8) and the outer bearing ring (9),
   - wherein, for each electric arc discharge, at least one value is sensed which is characteristic of the energy (E), the power, the voltage, the current and/or the duration (t) of the electric arc discharge concerned, and
   - wherein only those electric arc discharges are analysed for which a qualifying value (Q), determined as a function of at least one of the characteristic values sensed for the electric arc discharge concerned, lies above a predefined limiting value (G).

2. Analysis method according to claim 1, **characterised in that** the qualifying value (Q) is proportional to the energy (E) and inversely proportional to the cube of the duration (t) of the electric arc discharge concerned.

3. Analysis method according to claim 1 or claim 2, **characterised in that** the predefined limiting value (G) is determined with reference to the material of which the inner bearing ring (8) and/or the outer bearing ring (9) consist, by the heating enthalpy which is required in order to heat up the material from the operating temperature to the melting point temperature, by the enthalpy of fusion which is required in order to melt the material, and by the heating enthalpy which is required in order to heat up the material from its melting point temperature up to its boiling point temperature, wherein the enthalpies cited are relative to the same volume.

4. Analysis method according to claim 1, 2 or 3, **characterised in that** it is repeated for a plurality of operating states of the roller bearing (1), **in that** the frequency of the electric arc discharges which are being analysed is determined for each operating state, and **in that** the operating states are classified as permissible or impermissible, as a function of the frequency determined for the operating state concerned.

5. Analysis method according to claim 4, **characterised in that** into a non-volatile store, which is part of a drive controller for a converter-powered electric motor having a roller bearing (1), are written

   - either solely those operating states of the roller bearing (1) which are classified as permissible,
   - or solely those operating states of the roller bearing (1) which are classified as impermissible,
   - or both those operating states of the roller bearing (1) which are classified as permissible and also those operating states of the roller bearing (1) which are classified as impermissible, together with their classification in each case.

6. Drive controller for a converter-powered electric motor having a roller bearing (1), with a non-volatile store into which are written

- either solely those operating states of the roller bearing (1) which are classified as permissible,
- or solely those operating states of the roller bearing (1) which are classified as impermissible,
- or both those operating states of the roller bearing (1) which are classified as permissible and also those operating states of the roller bearing (1) which are classified as impermissible, together with their classification in each case, wherein the operating states written into the non-volatile store have been determined in accordance with an analysis method according to claim 4, and in each case the operating states of the roller bearing (1) include at least one of the parameters: rotational speed of the roller bearing; temperature of the roller bearing; an imbalance which causes vibrations imposed on the roller bearing; the lubricants; axial, radial, tilting loadings; tilting of the inner bearing ring relative to the outer bearing ring; the pulse shape and pulse repetition frequency of the applied electrical voltage; bearing play and pre-existing damage to the roller bearing.

7. Test stand for a roller bearing (1) which has an inner bearing ring (8), an outer bearing ring (9) and roller elements (10) which roll around between the inner bearing ring (8) and the outer bearing ring (9),

- wherein the test stand has a chassis (2),
- wherein the chassis (2) has a mounting arrangement (6), in which the roller bearing (1) can be removably mounted,
- wherein the mounting arrangement (6) consists of an electrically insulating material and/or is electrically insulated from the remainder of the chassis (2) by an intermediate element (7) consisting of an electrically insulating material,
- wherein the test stand has an electric drive (3), the rotational speed of which can be altered, which is arranged in a fixed location on the chassis (2) and acts on a shaft (5) which, when the roller bearing (1) is mounted, has a nonrotating joint to the inner bearing ring (8) or to the outer bearing ring (9),
- wherein the electric drive (3) is electrically insulated from the roller bearing (1),
- wherein the test stand has a voltage generator (11), by which the interface between the inner bearing ring (8) and the outer bearing ring (9) can be subjected to a pulse-shaped electric voltage (U) with an adjustable pulse shape and pulse repetition frequency,
- wherein the test stand has sensing equipment (13) by means of which it is possible to sense at least one value which is characteristic of the energy (E), the power, the voltage, the current and/or the duration (t) of electric arc discharges which occur between the inner bearing ring (8) and the outer bearing ring (9).

8. Test stand according to claim 7,
**characterised in that**
arranged on the shaft (5) is a loading bearing (17), by means of which a static and/or dynamic loading can be applied to the roller bearing (1).

9. Test stand according to claim 8,
**characterised in that**
the test stand has a hydraulic system (22) which works on the loading bearing (17) to apply the static and/or dynamic loading.

10. Test stand according to claim 8 or 9,
**characterised in that**
the loading which can be applied to the roller bearing (1) is axial, radial and/or asymmetric in its effect.

11. Test stand according to one of claims 7 to 10,
**characterised in that**
arranged on the shaft (5) is an imbalance disk (15), by means of which an imbalance which causes vibrations can be applied to the roller bearing (1).

12. Test stand according to claim 11,
**characterised in that**
the imbalance disk (15) has at least one retaining fixture (16) for holding an imbalance weight.

13. Test stand according to one of claims 7 to 12,
**characterised in that**
the test stand has at least one facility (14) for affecting the temperature, for actively setting an operating temperature for the roller bearing (1).

14. Test stand according to one of claims 7 to 13,
**characterised in that**
the test stand has an adjustment fixture (17), for tilting the inner bearing ring (8) relative to the outer bearing ring (9).

15. Test stand according to one of claims 7 to 14,
**characterised in that**
arranged on the mounting arrangement (6) are acceleration sensors (23), by means of which horizontal and/or vertical accelerations (a) of the mounting arrangement (6) can be sensed.

## Revendications

1. Procédé d'évaluation de décharges d'arc électrique, qui se produisent entre une bague ( 8 ) intérieure et une bague ( 9 ) extérieure d'un palier ( 1 ) à roulement,

   - dans lequel on règle un état de fonctionnement défini du palier ( 1 ) à roulement,
   - dans lequel, pour régler l'état de fonctionnement défini, on règle au moins l'un des paramètres vitesse ( n ) de rotation du palier ( 1 ) à roulement, température du palier ( 1 ) à roulement, balourd provoquant des oscillations agissant sur le palier ( 1 ) à roulement, agent de lubrification, charge axiale, radiale et de basculement, basculement de la bague ( 8 ) intérieure du palier par rapport à la bague ( 9 ) extérieure du palier, forme des impulsions et fréquence de répétition des impulsions de la tension ( U ) électrique appliquée, jeu du palier et endommagement préalable du palier ( 1 ) à roulement,
   - dans lequel, dans l'état de fonctionnement défini, on produit une pluralité de décharges d'arc électrique en appliquant une tension ( U ) électrique pulsée entre la bague ( 8 ) intérieure du palier et la bague ( 9 ) extérieure du palier,
   - dans lequel, pour chaque décharge d'arc électrique, on détecte au moins une valeur, qui est caractéristique de l'énergie ( E ), de la puissance, de la tension, du courant et/ou de la durée ( t ) de chaque décharge d'arc électrique, et
   - dans lequel on n'évalue que les décharges d'arc électrique, dans lesquelles une valeur ( Q ) qualifiante, déterminée en fonction d'au moins l'une des valeurs caractéristiques détectées de chaque décharge d'arc électrique, est supérieure à une valeur ( G ) limite déterminée à l'avance.

2. Procédé d'évaluation suivant la revendication 1, **caractérisé en ce que** la valeur ( Q ) qualifiante est proportionnelle à l'énergie ( E ) et inversement proportionnelle à la puissance troisième de la durée ( t ) de chaque décharge d'arc électrique.

3. Procédé d'évaluation suivant la revendication 1 ou 2, **caractérisé en ce que** la valeur ( G ) limite déterminée à l'avance est déterminée, en ce qui concerne le matériau dont est constituée la bague ( 8 ) intérieure du palier et/ou la bague ( 9 ) extérieure du palier, par l'enthalpie d'échauffement, qui est nécessaire pour porter le matériau de la température de fonctionnement au point de fusion, par l'enthalpie de fusion, qui est nécessaire pour faire fondre le matériau, et par l'enthalpie d'échauffement, qui est nécessaire pour porter le matériau du point de fusion au point d'ébullition, les enthalpies mentionnées se rapportant au même volume.

4. Procédé d'évaluation suivant la revendication 1, 2 ou 3, **caractérisé en ce qu'**on le répète pour une pluralité d'états de fonctionnement du palier ( 1 ) à roulement, **en ce qu'**on détermine, pour chaque état de fonctionnement, la fréquence des décharges d'arc électrique évaluées et **en ce qu'**on classe, comme admissibles ou comme inadmissibles, les états de fonctionnement en fonction de la fréquence déterminée pour l'état de fonctionnement respectif.

5. Procédé d'évaluation suivant la revendication 4, **caractérisé en ce qu'**on inscrit dans une mémoire rémanente, qui fait partie d'un dispositif de commande d'un moteur électrique alimenté par un convertisseur et ayant un palier ( 1 ) à roulement

   - soit seulement les états de fonctionnement du palier ( 1 ) à roulement classés comme admissibles,
   - soit seulement les états de fonctionnement du palier ( 1 ) à roulement classés comme inadmissibles,
   - ou ensemble avec leur classification respective, à la fois les états de fonctionnement du palier ( 1 ) à roulement classés comme admissibles et les états de fonctionnement du palier ( 1 ) à roulement classés comme inadmissibles.

6. Commande d'entraînement d'un moteur électrique alimenté par un convertisseur et ayant un palier ( 1 ) à roulement, comprenant une mémoire rémanente, dans laquelle sont inscrits

   - soit seulement les états de fonctionnement du palier ( 1 ) à roulement classés comme admissibles,
   - soit seulement les états de fonctionnement du palier ( 1 ) à roulement classés comme inadmissibles,
   - ou ensemble avec leur classification respective, à la fois les états de fonctionnement du palier ( 1 ) à roulement classés comme admissibles et les états de fonctionnement du palier ( 1 ) à roulement classés comme inadmissibles,

   dans laquelle les états de fonctionnement inscrits dans la mémoire rémanente ont été déterminés suivant un procédé d'évaluation selon la revendication 4 et les états de fonctionnement du palier ( 1 ) à roulement comprennent respectivement au moins l'un des paramètres vitesse de rotation du palier à roulement, température du palier à roulement, balourd provoquant des oscillations agissant sur le palier à roulement, agent de lubrification, charge axiale, radiale et de basculement, basculement de la bague intérieure du palier par rapport à la bague extérieure du palier, forme des impulsions et fréquence de répétition des impulsions de la tension électrique appliquée, jeu du palier et endommagement préalable du palier à roulement.

7. Banc d'essai d'un palier ( 1 ) à roulement, qui a une bague ( 8 ) intérieure de palier, une bague ( 9 ) extérieure de palier et des éléments ( 10 ) à roulement entre la bague ( 8 ) intérieure de palier et la bague ( 9 ) extérieure de palier,

   - dans lequel le banc d'essai a une embase ( 2 ),
   - dans lequel l'embase ( 2 ) a un agencement ( 6 ) de montage, dans lequel le palier ( 1 ) à roulement peut être monté de manière amovible,
   - dans lequel l'agencement ( 6 ) de montage est constitué en un matériau isolant électriquement et/ou est isolé électriquement du reste de l'embase ( 2 ) par un élément ( 7 ) intermédiaire en un matériau isolant du point de vue électrique,
   - dans lequel le banc d'essai a un entraînement ( 3 ) électrique, dont la vitesse de rotation peut être modifiée, qui est monté à poste fixe sur l'embase ( 2 ) et qui agit sur un arbre ( 5 ), qui, lorsque le palier ( 1 ) à roulement est monté, est solidaire en rotation de la bague ( 8 ) intérieure du palier ou de la bague ( 9 ) extérieure du palier,
   - dans lequel l'entraînement ( 3 ) électrique est isolé électriquement du palier ( 1 ) à roulement,
   - dans lequel le banc d'essai a un générateur ( 11 ) de tension, par lequel le passage de la bague ( 8 ) intérieure du palier à la bague ( 9 ) extérieure du palier peut être alimenté en une tension ( U ) électrique pulsée ayant une forme d'impulsion ou une fréquence de répétition des impulsions qui est réglable,
   - dans lequel le banc d'essai a un dispositif ( 13 ) de détection, au moyen duquel peut être déterminée au moins une valeur, qui est caractéristique de l'énergie ( E ), de la puissance, de la tension, du courant et/ou de la durée ( t ) de décharges d'arc électrique se produisant entre la bague ( 8 ) intérieure du palier et la bague ( 9 ) extérieure du palier.

8. Banc d'essai suivant la revendication 7, **caractérisé en ce que**, sur l'arbre ( 5 ), est monté un palier ( 17 ) de charge, au moyen duquel une charge statique et/ou dynamique peut être appliquée au palier ( 1 ) à roulement.

9. Banc d'essai suivant la revendication 8, **caractérisé en ce que** le banc d'essai a, pour l'application de la charge statique et/ou dynamique, un système ( 22 ) hydraulique agissant sur le palier ( 17 ) de charge.

10. Banc d'essai suivant la revendication 8 ou 9, **caractérisé en ce que** la charge pouvant être appliquée sur le palier ( 1 ) à roulement agit axialement, radialement et/ou dissymétriquement.

11. Banc d'essai suivant l'une des revendications 7 à 10, **caractérisé en ce que**, sur l'arbre ( 3 ), est monté un disque ( 15 ) de balourd, au moyen duquel un balourd provoquant des oscillations peut être appliqué au palier ( 1 ) à roulement.

12. Banc d'essai suivant la revendication 11, **caractérisé en ce que** le disque ( 15 ) de balourd a au moins un dispositif ( 16 ) de maintien pour maintenir une masselotte de balourd.

13. Banc d'essai suivant l'une des revendications 7 à 12, **caractérisé en ce que** le banc d'essai a au moins un dispositif ( 14 ) influençant la température pour le réglage actif d'une température de fonctionnement du palier ( 1 ) à roulement.

14. Banc d'essai suivant l'une des revendications 7 à 13, **caractérisé en ce que** le banc d'essai a un dispositif ( 17 ) de réglage pour faire basculer la bague ( 8 ) intérieure du palier par rapport à la bague ( 9 ) extérieure du palier.

15. Banc d'essai suivant l'une des revendications 7 à 14, **caractérisé en ce que**, sur l'agencement ( 6 ) de montage, sont montés des capteurs ( 23 ) d'accélération, au moyen desquels des accélérations ( a ) horizontales et/ou verticales du dispositif ( 6 ) de montage peuvent être détectées.

FIG 1

# FIG 2

stelle einen definierten Betriebszustand ein — S1

lege die vom Spannungsgenerator abgegebene elektrische Spannung zwischen Lagerinnenring und Lageraußenring an — S2

erfasse für die Energie, die Leistung, die Spannung, den Strom und/oder die Dauer der auftretenden Lichtbogenentladungen charakteristische Werte — S3

ermittle einen die jeweiligen Lichtbogenentladung qualifizierenden Wert Q vorzugsweise: $Q = E / t^3$ — S4

S5
Q > G? −
+

werte die entsprechende Lichtbogenentladung aus — S6

S7
Betriebszustand beenden? −
+

klassifiziere den eingestellten Betriebszustand entsprechend der Auswertung — S8

S9
alle Betriebszustände? −
+

S10
stelle den nächsten Betriebszustand des Wälzlagers ein

S11
schreibe in einen nichtflüchtigen Speicher, der Bestandteil einer Antriebssteuerung ist, ein
- nur die zulässigen Betriebszustände
- oder nur die unzulässigen Betriebszustände
- oder zusammen mit ihrer Klassifizierung sowohl die zulässigen als auch die unzulässigen Betriebszustände

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4441828 A1
- US 2005184751 A1
- DE 4410639 A1
- DE 19844822 A1